# FASCICULE DE BREVET EUROPEEN

(11) **EP 1 713 132 B1**
(45) Date de publication et mention de la délivrance du brevet: **20.05.2015**
(21) Numéro de dépôt: 06290526.0
(22) Date de dépôt: 31.03.2006
(51) Int. Cl.: G01J 1/02, H01L 31/09, H01L 27/146, G01J 1/04, H01L 31/0216, G01J 1/42

(54) **Capteur photosensible et ses applications dans le domaine automobile**
Photosensor und Anwendung desselben im Kraftfahrzeug-Bereich
Photosensitive sensor and its applications on the automotive field

(30) Priorité: 11.04.2005 FR 0503580
(43) Date de publication de la demande: 18.10.2006
(73) Titulaire: VALEO VISION, 93012 Bobigny Cedex (FR)
(72) Inventeur: Fleury, Benoist, 94300 Vincennes (FR)
(74) Mandataire: Schaffner, Jean

(56) Documents cités:
- US-A- 4 651 001
- US-A- 4 663 656
- US-A- 5 801 373
- US-A1- 2003 001 093
- US-A1- 2003 205 661

## Description

La présente invention concerne des capteurs, par exemple du type capteur CCD (capteurs à couplage de charge), capteur CMOS (Complementary Metal Oxide Semiconductor) ou encore du type caméra video. Ces capteurs ou caméras seront regroupés dans la suite du présent texte sous le terme générique de capteurs photosensibles. Ils fournissent des signaux représentatifs d'image qui peuvent ensuite être traités. Ils sont généralement sensibles dans le visible et/ou dans l'infrarouge, notamment dans le proche infrarouge.

Le document US 5801373 décrit un capteur d'images muni d'un filtre de couleur.

On intègre de plus en plus fréquemment ce type de capteurs photosensibles dans des véhicules automobiles. Les images obtenues peuvent être traitées pour permettre l'affichage d'images sur des écrans, par exemple au niveau du tableau de bord ou en projection sur le pare-brise, notamment pour alerter le conducteur en cas de danger ou simplement pour améliorer sa visibilité. Elles peuvent aussi participer au déclenchement automatique d'une fonctionnalité du véhicule (déclenchement automatique de freinage, avertissement visuel ou sonore, pilotage de certaines fonctions du projecteur ...). Ces capteurs peuvent être utilisés de jour. Ils peuvent aussi être utilisés de nuit, on exploite alors plutôt leurs capacités à détecter les rayonnements dans l'infrarouge. En utilisation nocturne, ces capteurs participent ainsi par exemple à la fonctionnalité « vision de nuit » (ou « night vision » en anglais), où les images, une fois traitées, sont projetées sur un écran d'affichage généralement sous forme d'images en noir et blanc.

Cependant, on ne peut guère envisager d'utiliser tel quel le même capteur embarqué sur un véhicule en utilisation diurne et en utilisation nocturne, même si, en principe, il peut être capable de détecter aussi bien le visible que l'infrarouge. En effet, si l'on utilise un capteur sensible aux infrarouges pour qu'il puisse « voir » la nuit, de jour, la réverbération du soleil sur la route dans les zones proches du véhicule va entraîner facilement une saturation de celui-ci dans l'infrarouge : cette saturation tend à le rendre inapproprié à un usage diurne, avec une perte de la qualité des images obtenues. (On utilisera dans le présent texte le mot image au sens large, à savoir tout signal ou ensemble de signaux reçus ou restitués par le capteur photosensible.)

Pour avoir des images avec la qualité requise avec ces types de capteurs aussi bien de jour que de nuit et quel que soit l'ensoleillement, on a jusqu'à présent deux solutions.

La première solution consiste à utiliser deux capteurs, un premier capteur dédié à une utilisation diurne et équipé d'un filtre « coupant » les infrarouges pour éviter toute saturation en cas d'ensoleillement, et un second capteur dédié à une utilisation nocturne. L'inconvénient de cette première solution est qu'il faut deux capteurs, ce qui augmente le coût, la complexité et l'encombrement du système exploitant les images recueillies par les capteurs.

La seconde solution consiste à utiliser un seul capteur, et à l'équiper d'un filtre amovible apte à filtrer les infrarouges : en utilisation diurne avec fort ensoleillement, le filtre est actif et évite la saturation du capteur en infrarouge. Par contre, le filtre est retiré en utilisation nocturne et en utilisation diurne avec un faible ensoleillement. Cette solution n'est pas non plus dénuée d'inconvénients : prévoir une pièce mobile dans un capteur est complexe, et présente un risque de mal fonctionnement. En outre, il est nécessaire de prévoir des moyens pour détecter les conditions environnementales jour/nuit/taux d'ensoleillement, moyens complexes, coûteux et susceptibles de défaillances.

L'invention a donc pour but de remédier aux inconvénients des solutions existantes. Plus précisément, l'invention a pour but la mise au point de nouveaux capteurs photosensibles aptes à apporter une qualité d'image satisfaisante aussi bien de jour que de nuit, et qui soient notamment plus simples et/ou plus fiables.

L'invention a tout d'abord pour objet un capteur photosensible comme définit dans la revendication 1.

L'invention a permis de résoudre ingénieusement le problème posé. En effet, de jour, une partie significative des infrarouges reçus par le capteur provient de la réflexion diffusante sur la route des infrarouges émis par le soleil, à proximité de l'avant du véhicule, le capteur étant généralement disposé selon un plan sensiblement vertical, par exemple dans le bouclier du véhicule ou dans l'habitacle à proximité du pare-brise. Et cette part d'infrarouges réfléchis, susceptible de saturer le capteur en infrarouge, tend à n'atteindre qu'une partie de sa zone réceptrice, la zone la plus basse plus particulièrement dans la configuration habituelle du capteur. L'invention a alors exploité cette observation en proposant un filtre qui module localement son effort de filtration vis-à-vis des rayonnements gênants, tout particulièrement les infrarouges, notamment dans le proche infrarouge. Ainsi, de nuit, on laisse suffisamment d'infrarouges atteindre le capteur pour obtenir une image de qualité suffisante. Et de jour, par fort ensoleillement, le filtre retire suffisamment d'infrarouge des rayonnements reçus par le capteur pour éviter sa saturation dans les zones où le risque de saturation est le plus grand, tout en gardant une qualité d'image satisfaisante.

On a ainsi un capteur unique nocturne/diurne, sans pièce mobile et dont les performances restent bonnes quel que soit le niveau d'ensoleillement le jour. On gagne bien sûr en simplicité d'installation du capteur, en simplicité d'intégration dans un système de traitement de l'image, en coût, ainsi qu'en fiabilité du fonctionnement du capteur, qui est dépourvu de pièces mobiles. On aurait pu cependant craindre qu'un tel choix aboutisse à un mauvais compromis en termes de performances, avec un capteur donnant des images trop dégradées la nuit et le jour quand il y a un faible ensoleillement, mais, de façon surprenante, cela ne s'est pas avéré le cas.

Dans l'invention, le filtre a un taux de filtrage des rayonnements qui varie localement.

Avantageusement, la zone réceptrice du capteur est disposée, en position d'usage, selon un plan sensiblement vertical ou oblique et le filtre affecte une partie de la zone réceptrice située en partie inférieure ou en partie supérieure de ladite zone, soit la zone qui correspond à une partie inférieure de l'objet ou de la scène. Les termes « objet « et scène » sont compris dans leur acceptation habituelle dans le domaine des caméras et des capteurs. En effet, selon le train de moyens optiques de type lentille utilisé comme objectif associé au capteur, on a soit une correspondance entre le bas de la scène et le bas de la zone réceptrice, soit une inversion, le bas de la scène correspondant alors au haut de la zone réceptrice du capteur. Par la suite, pour plus de commodité, on pourra considérer que le bas de la zone réceptrice correspond au bas de la scène, en fonction notamment du train de lentilles pour la formation de l'image, mais cela n'a pas un caractère limitatif.

Comme brièvement expliqué plus haut, c'est en effet dans la partie la plus basse du capteur (ou la plus haute selon le type d'objectif, comme mentionné précédemment) que l'intensité des rayonnements infrarouges émis par le soleil et ré émis par la route à courte distance du véhicule sera la plus importante (en prenant la convention que les termes haut, bas, inférieur, supérieur, se rapportent au capteur placé dans sa configuration d'usage notamment une fois monté dans le véhicule, avec un objectif sans inversion d'image).

Beaucoup de modes de réalisation sont possibles, du plus simple au plus sophistiqué. Dans la présente invention la zone réceptrice est sensiblement verticale et sensiblement carrée ou rectangulaire, avec une zone inférieure (respectivement supérieure) filtrée et une zone supérieure (respectivement inférieure) non filtrée, avec une ligne de séparation entre les deux zones qui est une simple ligne droite sensiblement horizontale rejoignant les deux bords opposés de la zone réceptrice. On peut aussi avoir une ligne de séparation qui n'est pas rectiligne, mais qui peut être courbe.

On peut aussi avoir une mosaïque de plusieurs zones filtrées et de une ou plusieurs zones non filtrées. On peut prévoir des zones filtrées à des niveaux différents qui sont contiguës ou séparées les unes des autres par des zones non filtrées, ou des zones filtrées à des niveaux de filtration identiques et séparées par une ou plusieurs zones non filtrées. Les zones filtrées peuvent avoir des niveaux de filtration différents, graduels par exemple, avec plusieurs zones superposées de plus en plus filtrées du haut vers le bas. On peut aussi avoir une zone réceptrice entièrement filtrée, avec un taux de filtrage par exemple extrêmement faible en haut et de plus en plus fort vers le bas. On peut aussi avoir des zones dont le taux de filtrage ne varie pas seulement du haut vers le bas, mais, par exemple, également des bords vers la partie médiane de la zone réceptrice.

On voit ainsi que l'on peut mettre en oeuvre l'invention de façon très variée, selon notamment la position du capteur dans le véhicule, son dimensionnement, le climat du pays où le véhicule est destiné à rouler, les exigences sur la qualité des images de nuit etc....

Avantageusement, la zone réceptrice du capteur est disposée, en position d'usage, selon un plan sensiblement vertical ou oblique, et le filtre affecte au moins le quart ou le tiers inférieur (respectivement supérieur) de la hauteur de la zone réceptrice. Par exemple, le filtre peut affecter au moins 25%, notamment au moins 30% ou au moins 50%, de la surface de la zone réceptrice. Il peut aussi affecter au plus 65%, notamment au plus 60% ou au plus 50%, de la surface de la zone réceptrice du capteur.

Selon un mode de réalisation, le filtre affecte substantiellement toute la surface de la zone réceptrice du capteur, avec un taux de filtrage graduel selon la hauteur de la zone réceptrice (du bas vers le haut ou inversement), en position d'usage du capteur.

Concernant la réalisation pratique du filtre selon l'invention, on peut par exemple utiliser un écran de type substrat (verre, plastique ou tout autre matériau transparent dans le visible et dans le proche infrarouge) muni d'au moins une couche mince de type interférentielle filtrante ou d'un vernis filtrant ou munis d'additifs/teinté dans la masse. Dans la variante où le filtre n'affecte qu'une partie de la zone réceptrice du capteur, on peut choisir d'utiliser ce type d'écran de dimensionnement approprié pour n'avoir d'impact que sur une partie de la zone réceptrice. Pour faciliter la fabrication ou le montage du filtre et pour éviter tout risque de perte de qualité d'image entre la zone filtrée et la zone non filtrée, on peut aussi préférer utiliser un filtre qui est constitué d'un écran qui a une partie neutre -le substrat nu-, non ou substantiellement non filtrante, et une ou plusieurs autres parties filtrantes -le substrat muni de couche(s) mince(s) ou d'un vernis ou d'additifs - et actives donc vis-à-vis de zones correspondantes réceptrices sur le capteur.

Pour obtenir un écran qui présente différents niveaux de filtrage, on peut le munir d'au moins deux zones munie de couche(s) mince(s) de nature et/ou de nombre et/ou ou d'épaisseur différent(es). Les dispositifs de dépôt de couche mince, du type pulvérisation cathodique par exemple, permettent en effet de régler très précisément la surface, l'épaisseur de chaque couche, ainsi que la séquence de couches dans un empilement de couches.

De préférence, le filtre est disposé sur ou à proximité de la zone réceptrice du capteur, ou est disposé sur ou à proximitéd'un plan plan image intermédiaire du capteur, ou est disposé au-delà de l'objectif associé au capteur.

Le capteur selon l'invention s'intègre parfaitement dans une fonction de vision de nuit d'un véhicule automobile.

L'invention a également pour objet le dispositif de traitement d'images embarqué sur un véhicule automobile utilisant au moins le capteur décrit plus haut.

L'invention a également pour objet le procédé de traitement d'images utilisant les signaux reçus par le capteur embarqué sur un véhicule automobile décrit plus haut.

Enfin, l'invention a également pour objet le véhicule automobile muni d'un tel capteur.

L'invention sera détaillée ci-après avec des exemples non limitatifs, à l'aide des figures suivantes :
- **fig.1** : une représentation schématique d'un véhicule sur route muni d'un capteur selon l'invention,
- **fig. 2** : une représentation schématique du champ de vision du capteur de la figure 1 avec un premier filtre,
- **fig. 3** **:** une représentation schématique du champ de vision du capteur de la figure 1 avec un second filtre,
- **fig. 4a,4b,4c** : des représentations schématiques de différentes variantes de capteur selon l'invention associé à un objectif,
- **Fig. 5a,5b**: des représentations schmématiques d'un objectif particuleur associé au capteur selon les figures 4a,4b et 4c.

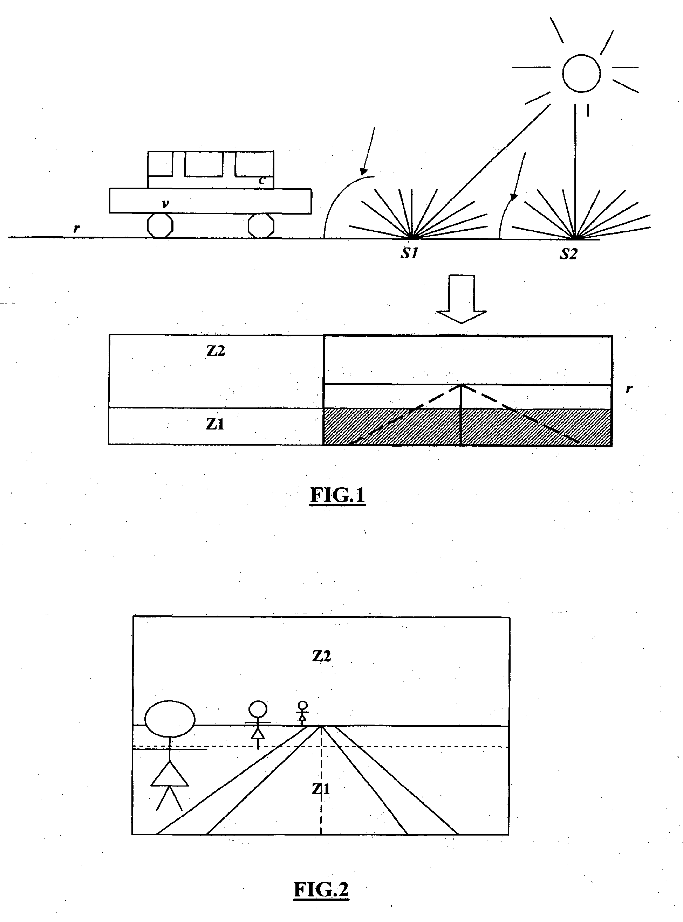

La figure 1 représente de façon très schématique, et sans respecter l'échelle pour plus de clarté, une route r sur laquelle roule un véhicule v. Ce véhicule est équipé d'un capteur c photosensible vis-à-vis du visible et du proche infrarouge et disposé derrière le pare-brise. De jour, en cas de fort ensoleillement, le soleil émet un rayonnement important dans le proche infrarouge en direction de la route. Des rayons infrarouges sont alors réfléchis, de façon diffusante, par la route. Ceux qui sont réfléchis dans une zone s1 proche du véhicule (jusqu'à par exemple 30 mètres à l'avant du véhicule) vont atteindre la zone réceptrice du capteur c avec une intensité assez importante, alors que les rayon réfléchis à une distance plus grande de l'avant du véhicule (par exemple au-delà de 30 mètres de l'avant du véhicule), dans la zone s2, n'affecteront que peu le capteur, ce que montre la représentation, au bas de la figure 1, de la route à l'avant du véhicule. En journée, la grande quantité d'infrarouges émise par le soleil puis réfléchie par la route peut saturer le capteur sans filtre. On obtient alors une image avec des pertes d'informations, donc une image médiocre. Si, pour parer à cet inconvénient, on munit le capteur d'un filtre qui va filtrer les infrarouges, le capteur devient inutilisable la nuit.

L'invention a alors exploité cette observation pour concevoir un capteur qui puisse fonctionner de jour comme de nuit, en mettant au point un nouveau type de filtre :
La figure 2 représente le « champ de vision » du capteur muni d'un premier type de filtre, en correspondance avec sa surface réceptrice Z. Le filtre est placé devant la zone réceptrice du capteur de façon à filtrer les infrarouges de façon sélective : si, schématiquement on représente la zone réceptrice Z du capteur par un rectangle, on partage cette surface en deux : une zone Z2 démunie de filtre, qui correspond à environ la moitié supérieure du rectangle, et une zone Z1 munie d'un filtre filtrant au moins partiellement le proche infrarouge, correspondant à une surface complémentaire de Z2. On peut choisir dans la zone Z1 une filtration graduelle selon la hauteur h de la zone réceptrice Z. Le taux de filtration du proche infrarouge, s'il est constant, peut par exemple être d'au moins 70 ou 80%. S'il est graduel, il peut par exemple être au plus bas de 90 ou 100%, puis diminuer graduellement pour être, en haut de la zone Z1 de 50 ou 60 %. (ou inversement selon l'objectif associé au capteur).

Avec une zone réceptrice ainsi partagée en deux, le fonctionnement du capteur est bien amélioré de jour. En effet, la zone Z1, qui était celle la plus exposée à une saturation infrarouge quand le soleil est là, est filtrée, ce qui évite justement qu'elle ne sature : elle continue à capter correctement le visible et éventuellement un peu d'infrarouge si le taux de filtrage n'est pas de 100% : elle recueille assez d'informations pour restituer une image de qualité suffisante, en combinaison avec la zone Z2 non filtrée.

La nuit, la zone Z1 correspond à une portion de la route éclairée par les faisceaux de type code, émis dans le visible par les projecteurs du véhicule, alors que la zone Z2 correspond à la scène éclairée par les émetteurs d'infrarouge du véhicule s'il en est équipé. La zone Z2 est la zone qui « voit » le plus loin par rapport au véhicule, cette zone est la plus importante, notamment pour une intégration dans une fonction « night vision », car elle va permettre de détecter les obstacles au loin, permettant d'anticiper sur les actions éventuelles à prendre, par exemple anticiper un freinage manuellement ou automatiquement.

En fait, ce type de filtrage permet un fonctionnement de toute la zone réceptrice de jour sans saturation de l'image même par fort soleil. Et de nuit, elle privilégie la zone réceptrice la plus importante pour la fonction vision de nuit recherchée, sans pénaliser la zone plus porche du véhicule éclairée dans le visible par les projecteurs du véhicule. Dans les deux cas, l'image recueillie est de qualité suffisante pour l'utilisation prévue du capteur.

Le filtrage selon la figure 2 est de conception simple. L'invention peut ensuite prévoir de partager la zone réceptrice non pas en deux mais en beaucoup plus de zones, certaines filtrées, d'autres non, ou toutes filtrées mais avec un taux de filtration qui varie. Dans la plupart des cas, cependant, on trouvera avantage à localiser les zones filtrées vers le bas de la zone réceptrice, c'est-à-dire dans les zones qui seront le plus soumises au rayonnement infrarouge réfléchi par la route.

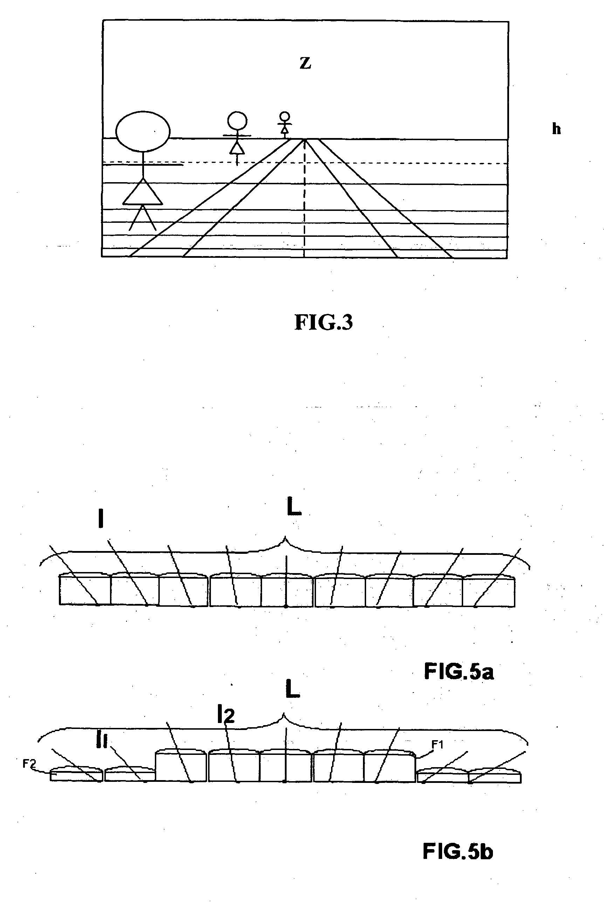

La figure 3 présente ainsi une variante du capteur selon la figure 1, où la zone réceptrice Z est filtrée graduellement, de façon linéaire ou non linéaire, sur sa hauteur h : en « bas », le taux de filtrage est par exemple de 90% pour diminuer jusqu'à 10% en « haut ». Cette gradation du filtrage favorise la restitution d'images de résolution plus homogène.

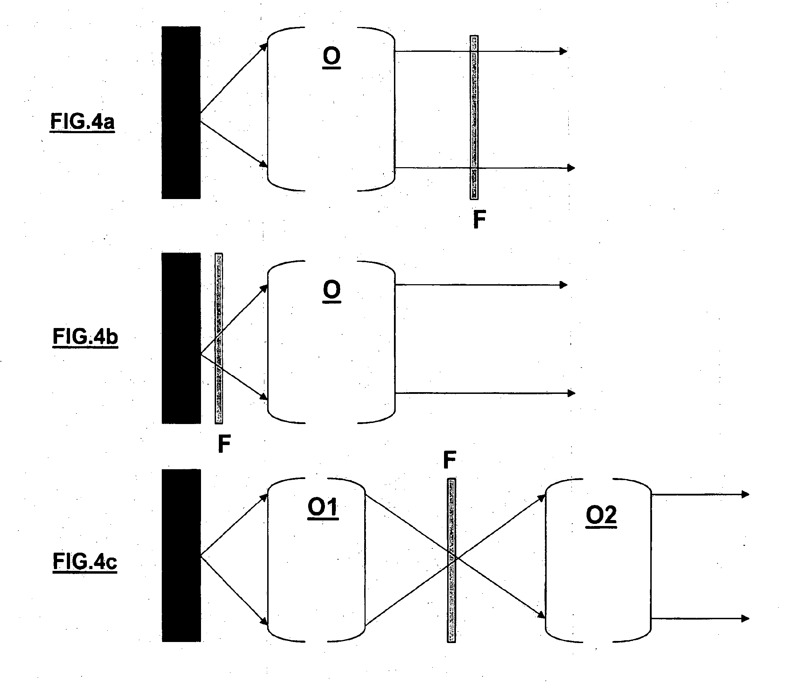

Les figures 4a,b,c représentent très schématiquement une section des capteurs munis selon l'invention de filtres et associés à des objectifs :
- à la figure 4a, on a représenté la zone réceptrice Z, puis un filtre F, qui est accolé à la zone Z et qui est constitué d'un substrat neutre ayant une haute transmission dans le visible et dans l'infrarouge, par exemple en verre clair, muni sur sa moitié inférieure d'un empilement de couches interférentielles approprié autorisant, comme le substrat, une bonne transmission dans le visible, mais hautement filtrant vis-à-vis du proche infrarouge. Le filtre F peut être contigu au capteur ou être placé à une très courte distance. Au-delà du filtre, est prévue un objectif O composé d'un train de lentilles conçu de façon à ce que l'image, comme représenté par les flèches, ne soit pas inversée en le traversant. C'est la configuration utilisée dans les exemples illustrés aux figures précédentes. Un tel filtre disposé devant la zone réceptrice permet d'obtenir un effet de filtrage sélectif selon la figure 2. Avoir un filtre avec une zone neutre peut faciliter son montage dans le capteur et améliore la qualité de l'image dans la zone de transition. Une variante consiste à ne conserver que la zone du filtre muni de couches interférentielles « en face « de la zone Z1. Pour obtenir le filtrage graduel selon la figure 3, on adapte par exemple le filtre en prévoyant une épaisseur croissante de couche(s) filtrante(s).
- la figure 4b est une variante de la précédente : le filtre F est disposé au-delà de l'objectif O, en reprenant les références de la figure 4a.
- la figure 4c est une autre variante : Ici, le filtre F est disposé dans le plan intermédiaire image de l'objectif partagé en deux trains de lentilles O1 et O2. Les flèches indiquent l'inversion d'image dans le plan du filtre F.

Selon encore une autre variante, l'objectif peut contenir des moyens optiques obtenus par des techniques micro-optiques, comme représenté à la figure 5. L'objectif O, notamment dans n'importe laquelle des configurations représentées aux figures 4a,4b et 4c, peut comprendre optionnellement un moyen optique, ici une lentille L, comportant une pluralité de microlentilles I. Ces microlentilles peuvent être sensiblement identiques et avoir la même distance focale, comme représenté à la figure 5a, ou non.

Un objectif de ce type est décrit dans l'article « Artificial apposition compound fabricated by micro-optics technology » de Jacques Duparré et Al, , publié dans Applied optics Volume 43, N° 22, 1er aout 2004.

On parle alors d'objectif anamorphique. Les microlentilles sont agencées par exemple selon un pas constant et sont associées à des pixels du capteur d'image également agencés selon un pas constant. Le pas des pixels est inférieur au pas des microlentilles de telle manière qu'un pixel considéré voit un angle de champ de plus en plus grand à mesure que le pixel s'écarte de l'axe de l'objectif.

Selon un autre mode de réalisation, représenté à la figure 5b, la lentille L comprend toujours une pluralité de microlentilles, mais réparties en deux types différents, I1 et I2, ayant des distances focales F1,F2 différentes. Avantageusement, on choisit d'associer cette lentille L à un capteur C dont les pixels ont un pas constant mais différent de celui des microlentilles 11 et 12. Le pas des pixels est de préférence inférieur au pas des microlentilles.

Avec cette technologie micro-optique, on peut ainsi obtenir des résolutions angulaires différentes pour la zone centrale et les zones latérales de la scène. La variation de la résolution de l'image peut se faire par palliers ou graduellement, notamment par une variation correspondante du pas des pixels ou des microlentilles.

L'invention trouve ainsi application dans le domaine automobile, mais est également applicable dans tout autre domaine où l'on a besoin d'un capteur qui soit efficace de jour comme de nuit, notamment pour tout équiper tout moyen de locomotion aérien, terrestre ou maritime.

L'invention réside notamment dans le fait, pour un mode de réalisation préféré, que la zone réceptrice du capteur comprend une ligne de partage entre une première zone (en dessus de cette ligne) où l'on a besoin des rayonnements infrarouge, tous les pixels concernés étant sensibilisés vis-à-vis de l'infrarouge, et une autre zone (en dessous de cette ligne) où l'on doit au contraire filtrer les rayonnements infrarouge, les pixels concernés étant sensibilisés vis-à-vis du rayonnement visible.

La multi fonctionnalité du capteur selon l'invention est un grand atoût : on peut ainsi l'intégrer à la fois dans un système de type vision de nuit, dans un système de type LDWS (en anglais « Lane Departure Warning Signal », en français avertissement de sortie de voie involontaire) et dans un système de commutation automatique des projecteurs d'un mode d'éclairage à un autre, d'un mode « route » à un mode « code » notamment.

## Revendications

1. Capteur (C) diurne et nocturne pour véhicule automobile, photosensible vis-à-vis d'au moins une partie du rayonnement dans l'infrarouge et d'au moins une partie du rayonnement dans le visible, **caractérisé en ce que** ledit capteur est muni d'un filtre (F)
- affectant tout ou partie de la zone réceptrice (Z) du capteur (C),
- apte à filtrer des rayonnements dans l'infra-rouge dans des longueurs d'onde auxquelles le capteur est sensible, et qui présente un taux de filtrage (f) qui varie localement, le taux de filtrage (f) étant graduel selon la hauteur (h) de la zone réceptrice (Z), la zone réceptive (z) étant sensiblement verticale et sensiblement carrée ou rectangulaire avec une hauteur h.

2. Capteur selon l'une des revendications précédentes, **caractérisé en ce que** le filtre (F) filtre des rayonnements dans le proche infrarouge.

3. Capteur selon l'une des revendications précédentes, **caractérisé en ce que** le filtre (F) affecte une partie (Z1) de la zone réceptrice (Z), située en partie inférieure ou supérieure de ladite zone (Z), qui correspond à une partie inférieure de l'objet ou de la scène.

4. Capteur selon la revendication précédente, **caractérisé en ce que** le filtre (F) affecte au moins le quart ou le tiers inférieur ou supérieur de la hauteur (h) de la zone réceptrice (Z).

5. Capteur selon l'une des revendications précédentes, **caractérisé en ce que** le filtre affecte au moins 25%, notamment au moins 30% ou au moins 50%, de la surface de la zone réceptrice (Z).

6. Capteur selon l'une des revendications précédentes, **caractérisé en ce que** le filtre affecte au plus 65%, notamment au plus 60% ou au plus 50%, de la surface de la zone réceptrice (Z).

7. Capteur selon l'une des revendications 1 à 5, **caractérisé en ce que** le filtre affecte substantiellement toute la surface (Z) de la zone réceptrice du capteur (C).

8. Capteur selon l'une des revendications précédentes, **caractérisé en ce que** le filtre (F) comporte un substrat muni d'au moins une couche mince de type interférentielle ou d'un vernis ou qui est filtrant dans la masse.

9. Capteur selon l'une des revendications précédentes, **caractérisé en ce que** le filtre (F) comporte un substrat comprenant au moins une zone active munie de couche(s) mince(s) de type interférentielle ou de vernis/revêtement et au moins une zone neutre dépourvue de couches minces ou de vernis/revêtement.

10. Capteur selon la revendication précédente, **caractérisé en ce que** le filtre (F) présente au moins deux zones munie de couche(s) mince(s) ou de vernis de nature et/ou de nombre et/ou ou d'épaisseur différent(es).

11. Capteur selon l'une des revendications précédentes, **caractérisé en ce que** le filtre (F) est disposé sur ou à proximité du capteur (C), ou dans ou à proximité d'un plan image intermédiaire dudit capteur (C).

12. Capteur selon l'une des revendications précédentes, **caractérisé en ce qu'**il est associé à un objectif (0,01,02) comportant un moyen optique de type lentille (L) muni d'une pluralité de microlentilles (l,l1,l2), de pas et/ou de distance focale constants ou variables.

13. Capteur selon l'une des revendications précédentes, **caractérisé en ce qu'**il est intégré dans une fonction de vision de nuit d'un véhicule automobile.

14. Dispositif de traitement d'images embarqué sur un véhicule automobile, **caractérisé en ce qu'**il utilise au moins un capteur (C) selon l'une des revendications précédentes.

15. Procédé de traitement d'images, **caractérisé en ce qu'**il utilise les signaux reçus par un capteur (C) embarqué sur un véhicule automobile selon l'une des revendications précédentes.

## Patentansprüche

1. Tageslicht- oder Nachtsichtsensor (C) für Kraftfahrzeuge, der für wenigstens einen Teil der Infrarotstrahlung und wenigstens einen Teil der sichtbaren Strahlung lichtempfindlich ist,
**dadurch gekennzeichnet, dass** der Sensor mit einem Filter (F) versehen ist, der
- auf den ganzen Empfangsbereich (Z) des Sensors (C) oder einen Teil davon wirkt,
- Strahlungen im Infrarotbereich in Wellenlängen zu filtern vermag, für die der Sensor empfindlich ist, und der einen Filterungsgrad (f) aufweist, der stellenweise variiert, wobei der Filterungsgrad (f) entsprechend der Höhe (h) des Empfangsbereichs (Z) schrittweise erfolgt, wobei der Empfangsbereich (Z) im Wesentlichen senkrecht und im Wesentlichen quadratisch oder rechteckig mit einer Höhe h ist.

2. Sensor nach dem vorhergehenden Anspruch,
**dadurch gekennzeichnet, dass** der Filter die Strahlen im Nah-Infrarotbereich filtert.

3. Sensor nach einem der vorhergehenden Ansprüche,
**dadurch gekennzeichnet, dass** der Filter (F) auf einen Teil (Z1) des Empfangsbereichs (Z) wirkt, der im unteren oder oberen Teil des Bereichs (Z) liegt und der einem unteren Teil des Objekts oder der Szene entspricht.

4. Sensor nach dem vorhergehenden Anspruch,
**dadurch gekennzeichnet, dass** der Filter (F) wenigstens auf das untere oder obere Viertel oder Drittel der Höhe (h) des Empfangsbereichs (Z) wirkt.

5. Sensor nach einem der vorhergehenden Ansprüche,
**dadurch gekennzeichnet, dass** der Filter auf wenigstens 25 %, insbesondere wenigstens 30 % oder wenigstens 50 % der Oberfläche des Empfangsbereichs (Z) wirkt.

6. Sensor nach einem der vorhergehenden Ansprüche,
**dadurch gekennzeichnet, dass** der Filter auf höchstens 65 %, insbesondere höchstens 60 % oder höchstens 50 % der Oberfläche des Empfangsbereichs (Z) wirkt.

7. Sensor nach einem der Ansprüche 1 bis 5,
**dadurch gekennzeichnet, dass** der Filter auf im Wesentlichen die gesamte Oberfläche des Empfangsbereichs (Z) des Sensors (C) wirkt.

8. Sensor nach einem der vorhergehenden Ansprüche,
**dadurch gekennzeichnet, dass** der Filter (F) ein Substrat umfasst, das mit wenigstens einer dünnen Interferenzschicht oder einer Lackierung versehen ist oder das in einem Stück filtert.

9. Sensor nach einem der vorhergehenden Ansprüche,
**dadurch gekennzeichnet, dass** der Filter (F) ein Substrat umfasst, das wenigstens einen mit einer oder mehreren dünnen Interferenzschichten oder einem Lack/einer Beschichtung versehenen aktiven Bereich und wenigstens einen neutralen Bereich ohne dünne Schichten oder Lack/Beschichtung aufweist.

10. Sensor nach dem vorhergehenden Anspruch,
**dadurch gekennzeichnet, dass** der Filter (F) wenigstens zwei Bereiche mit einer oder mehreren dünnen Schichten oder Lack unterschiedlicher Art und/oder unterschiedlicher Zahl und/oder unterschiedlicher Dicke aufweist.

11. Sensor nach einem der vorhergehenden Ansprüche,
**dadurch gekennzeichnet, dass** der Filter (F) auf dem Sensor (C) oder in dessen Nähe oder in einer Zwischenbildebene des Sensors (C) oder in deren Nähe angeordnet ist.

12. Sensor nach einem der vorhergehenden Ansprüche,
**dadurch gekennzeichnet, dass** er einem Objektiv (O, O1, O2) zugeordnet ist, das ein optisches Mittel vom Typ Linse (L) umfasst, das mit einer Vielzahl von Mikrolinsen (I, I1, 12) mit einem gleichmäßigen oder variablen Abstand und/oder einer gleichmäßigen oder variablen Brennweite versehen ist.

13. Sensor nach einem der vorhergehenden Ansprüche,
**dadurch gekennzeichnet, dass** er in eine Nachtsichtfunktion eines Kraftfahrzeugs integriert ist.

14. Vorrichtung zur Bildverarbeitung an Bord eines Kraftfahrzeugs,
**dadurch gekennzeichnet, dass** sie wenigstens einen Sensor (C) nach einem der vorhergehenden Ansprüche verwendet.

15. Verfahren zur Bildverarbeitung,
**dadurch gekennzeichnet, dass** es die Signale verwendet, die von einem Sensor (C) an Bord eines Kraftfahrzeug nach einem der vorhergehenden Ansprüche empfangen werden.

## Claims

1. Daytime and night-time sensor (C) for a motor vehicle, which is photosensitive relative to at least part of the radiation in the infrared spectrum and at least part of the radiation in the visible spectrum, **characterised in that** the said sensor is provided with a filter (F) which:
- affects all or part of the area of receipt (Z) of the sensor (C);
- can filter radiation in the infrared spectrum in wavelengths to which the sensor is sensitive, and has a filtering level (f) which varies locally, the filtering level (f) being gradual according to the height (h) of the area of receipt (Z), the area of receipt (Z) being substantially vertical and substantially square or rectangular with a height h.

2. Sensor according to one of the preceding claims¹, **characterised in that** the filter (F) filters radiation in the close infrared spectrum.

3. Sensor according to one of the preceding claims, **characterised in that** the filter (F) affects part (Z1) of the area of receipt (Z) situated in the lower or upper part of the said area (Z), which corresponds to a lower part of the object or of the scene.

4. Sensor according to the preceding claim, **characterised in that** the filter (F) affects at least the lower or upper quarter or third of the height (h) of the area of receipt (Z).

5. Sensor according to one of the preceding claims, **characterised in that** the filter affects at least 25%, in particular at least 30%, or at least 50%, of the surface of the area of receipt (Z).

6. Sensor according to one of the preceding claims, **characterised in that** the filter affects at the most 65%, in particular at the most 60%, or at the most 50%, of the surface of the area of receipt (Z).

7. Sensor according to one of claims 1 to 5, **characterised in that** the filter affects substantially all of the surface of the area of receipt (Z) of the sensor (C).

8. Sensor according to one of the preceding claims, **characterised in that** the filter (F) comprises a substrate provided with the least one thin layer of the interferential type, or of a varnish, or which filters in the mass.

9. Sensor according to one of the preceding claims, **characterised in that** the filter (F) comprises a substrate comprising at least one active area provided with a thin layer/thin layers of the interferential type, or of varnish/a coating, and at least one neutral area without thin layers or of varnish/a coating.

10. Sensor according to the preceding claim, **characterised in that** the filter (F) has at least two areas provided with a thin layer/thin layers, or with varnish which has a different nature and/or number and/or thickness.

11. Sensor according to one of the preceding claims, **characterised in that** the filter (F) is arranged on or in the vicinity of the sensor (C), or on or in the vicinity of an intermediate image plane of the said sensor (C).

12. Sensor according to one of the preceding claims, **characterised in that** it is associated with an object (O, 01, 02) comprising an optical means of the lens (L) type, provided with a plurality of micro-lenses (l, l1, l2), with a constant or variable pitch and/or focal distance.

13. Sensor according to one of the preceding claims, **characterised in that** it is integrated in a night vision function of a motor vehicle.

14. Image processing device on board a motor vehicle, **characterised in that** it uses at least one sensor (C) according to one of the preceding claims.

15. Method for processing of images, **characterised in that** it uses signals received by a sensor (C) on board a motor vehicle, according to one of the preceding claims.
